Europäisches Patentamt

European Patent Office

Office européen des brevets

(19)

(11) EP 0 842 969 A1

(12) DEMANDE DE BREVET EUROPEEN

(43) Date de publication:
20.05.1998 Bulletin 1998/21

(51) Int Cl.6: **C08J 5/18**, C08L 77/00,
C08L 77/12

(21) Numéro de dépôt: 97402684.1

(22) Date de dépôt: 10.11.1997

(84) Etats contractants désignés:
AT BE CH DE DK ES FI FR GB GR IE IT LI LU MC
NL PT SE

(30) Priorité: 19.11.1996 FR 9614150

(71) Demandeur: ELF ATOCHEM S.A.
92800 Puteaux, Hauts-de-Seine (FR)

(72) Inventeurs:
• Bouilloux, Alain
 27300 Bernay (FR)
• Alex, Patrick
 91470 Limours Pecqueuse (FR)

(74) Mandataire: Pochart, François et al
Cabinet Hirsch-Desrousseaux-Pochart,
34 rue de Bassano
75008 Paris (FR)

(54) **Matériau comprenant un polyamide, un polymère bloc polyamide-polyéther et une polyoléfine fonctionnalisée, films et objets obtenus à partir de celui-ci**

(57) L'invention a pour objet un matériau comprenant : (a) un polyamide; (b) un polymère à blocs PA et blocs polyéther PEG; (c) éventuellement une polyoléfine; et (d) une polyoléfine fonctionnalisée, les divers constituants étant présents en des quantités pondérales a, b, c et d, telles que : a > 0; b > 0; c + d > 0; a + b + c + d = 100; avec a/b > 0,2; (a + b)/(c + d) > 1; et b/(a + b + c + d) < 0,5.

L'invention a aussi pour objet un film imperrespirant et un objet antistatique obtenus à partir du matériau selon l'invention.

EP 0 842 969 A1

Printed by Jouve, 75001 PARIS (FR)

## Description

La présente invention concerne un matériau comprenant un polyamide, un polymère à blocs polyamide et blocs polyéther et une polyoléfine fonctionnnalisée, avec éventuellement une polyoléfine. L'invention concerne aussi un film imperrespirant et un objet antistatique obtenus à partir de ce matériau.

La demande EP-A-0 378 015, par exemple, décrit des films imperrespirants, c'est-à-dire perméables à la vapeur d'eau mais imperméables à l'eau, à base de polymère à blocs polyamide et blocs polyéther.

Le brevet US-P-4 970 274 décrit des mélanges polyamide et polymères à blocs polyamide et blocs polyéther, pour des applications par exemple de films. La proportion de polymère à blocs polyamide et blocs polyéther dans le mélange est décrite comme étant comprise entre 5 et 20% en poids, et l'avantage procuré par le mélange est de fournir des films destinés par exemple à l'emballage sous vide.

La demande EP-A-0 476 963 décrit des films perméables à la vapeur d'eau à base de polymère à blocs polyamide et blocs polyéthylèneglycol, mélangé avec (a) un polymère blocs sans bloc polyéthylèneglycol, (b) un polyamide, (c) un polyester ou (d) un polyuréthanne. Dans tous les exemples d'une part seule une combinaison avec seulement un polyamide est donné en exemple, et d'autre part la quantité de polymère à blocs polyamide et blocs polyéthylèneglycol est importante, 75 ou 50% en poids. Cette demande de brevet enseigne toujours que les propriétés d'imperrespirabilité sont conférées par la phase majoritaire.

Aucun de ces documents n'enseigne ni ne suggère la présente invention.

Ainsi, l'invention fournit un matériau comprenant :

(a) un polyamide;
(b) un polymère à blocs PA et blocs polyéther PEG;
(c) éventuellement une polyoléfine; et
(d) une polyoléfine fonctionnalisée;

les divers constituants étant présents en des quantités pondérales a, b, c et d, telles que :

$a > 0$; $b > 0$; $c + d > 0$; $a + b + c + d = 100$; avec
$a/b > 0{,}2$; $(a + b)/(c + d) > 1$; et $b/(a + b + c + d) < 0{,}5$.

Selon un mode de réalisation, dans le matériau, les divers constituants sont présents en des quantités pondérales a, b, c et d telles que :

$$2 > a/b > 0{,}5.$$

Selon un autre mode de réalisation, dans le matériau, les divers constituants sont présents en des quantités pondérales a, b, c et d telles que :

$$0{,}3 < b/(a + b + c + d) < 0{,}5.$$

Selon un autre mode de réalisation, dans le matériau, les blocs PA du polymère (b) sont des blocs PA6.

Dans le matériau selon l'invention, le polyamide peut être du PA6, du PA6,6 ou du PA12; selon un mode de réalisation, dans le matériau, le polyamide est du PA6.

Un matériau préféré est celui dans lequel le polyamide est du PA6 et le polymère à blocs PA et blocs polyéther PEG est un polymère à blocs PA6/PEG.

Un autre matériau préféré est celui dans lequel le polyamide est du PA6,6 et le polymère à blocs PA et blocs polyéther PEG est un polymère à blocs PA6/PEG.

Un autre matériau préféré est celui dans lequel le polyamide est du PA12 et le polymère à blocs PA et blocs polyéther PEG est un polymère à blocs PA12/PEG.

Un autre matériau préféré est celui dans lequel le polyamide est du PA6 et le polymère à blocs PA et blocs polyéther PEG est un polymère à blocs PA12/PEG.

Selon un mode de réalisation, la polyoléfine fonctionnalisée (d) est choisie parmi :

(d1) homo- ou copolymères d'éthylène et d'alpha-oléfine avec un monomère acide carboxylique, un anhydride d'un tel acide, un sel d'un tel acide, un époxyde insaturé, ledit monomère étant greffé ou terpolymérisé;
(d2) copolymères éthylène/(méth)acrylate d'alkyle/monomère insaturé à fonction acide carboxylique ou anhydride d'acide carboxylique, ledit monomère étant greffé ou terpolymérisé;

(d3) copolymères éthylène/(méth)acrylate d'alkyle/monomère insaturé à fonction époxy, ledit monomère étant greffé ou terpolymérisé;

(d4) copolymères éthylène/esters vinyliques d'acide carboxylique/monomère insaturé à fonction acide carboxylique ou anhydride d'acide carboxylique, ledit monomère étant greffé ou terpolymérisé;

ces polyoléfines fonctionnalisées étant éventuellement mélangées avec un réactif difonctionnel.

Selon un autre mode de réalisation, la polyoléfine (c) est du polyéthylène.

L'invention se rapporte aussi à un film imperrespirant et un objet antistatique obtenus à partir du matériau selon l'invention.

L'invention est maintenant décrite plus en détail dans la description qui suit.

On entend par polyamide (a) les produits de condensation :

d'un ou plusieurs amino-acides, tels que les acides aminocaproïque, amino-7-heptanoïque, amino-11-undécénoïque et amino-12-dodécanoïque; ou d'un ou plusieurs lactames correspondants par exemple caprolactame, oenanlactame et lauryllactame; ou

d'une ou plusieurs combinaisons sensiblement stoechiométriques d'une ou plusieurs diamines aliphatiques et/ou cycloaliphatiques et/ou aromatique-aliphatiques, ou de leurs sels, avec un ou plusieurs diacides carboxyliques aliphatiques ou aromatiques, ou leurs sels; des exemples de telles diamines sont l'hexaméthylènediamine, la dodécaméthylènediamine, la métaxylylènediamine, le bis(4-aminocyclohexyl)méthane (BACM), le bis (3-méthyl-4-amino-cyclohexyl)méthane (BMACM), et la triméthylhexaméthylènediamine, tandis que des exemples de tels diacides sont les acides téréphtalique, isophtalique, adipique, azélaïque, sébacique, subérique et docédanedicarboxylique; ou

tout mélange des monomères précités; et

tout mélange des produits de condensation résultant, éventuellement avec d'autres polymères compatibles avec les polyamides.

A titre d'exemple, le polyamide est le PA6, PA6,6, PA6,10, PA11, PA12, PA6,12 et PA12,12, le polyamide préféré étant le PA6, le PA6,6 ou le PA12. Le poids moléculaire des polyamides peut varier dans un large mesure, ce que l'homme de l'art appréciera.

Des mélanges de polyamides sont aussi possibles.

La polyoléfine (c) est un homopolymère ou copolymère d'alpha-oléfines ou de dioléfines, telles que par exemple, éthylène, propylène, butène-1, octène-1, butadiène.

A titre d'exemple, on peut citer :

- les homopolymères tels que polyéthylène, en particulier LDPE, HDPE, LLDPE ou VLDPE, polyéthylène métallocène ou polypropylène.
- les copolymères éthylène/alpha-oléfine tels que éthylène/propylène, les EPR.
- les copolymères blocs styrène/éthylène-butène/butadiène (SEBS), styrène/butadiène/styrène (SBS), styrène/isoprène/styrène (SIS), styrène/éthylène-propylène/styrène (SEPS) et éthylène/propylène/diène (EPDM).
- les copolymères de l'éthylène avec au moins un produit choisi parmi les sels ou les esters d'acides carboxyliques insaturés tel que le (méth)acrylate d'alkyle tel que l'acrylate de méthyle, ou les esters vinyliques d'acides carboxyliques saturés tel que l'acétate de vinyle, la proportion de comonomère pouvant atteindre 40% en poids.

Les copolymères mentionnés ci-dessus peuvent être copolymérisés de façon statistique ou séquencée et présenter une structure linéaire ou ramifiée.

Les polyoléfines présentent une densité par exemple comprise entre 0,86 et 0,965, et un indice d'écoulement à l'état fondu MFI par exemple compris entre 0,3 et 40. Les polyoléfines peuvent aussi être réticulées, par tout agent approprié (époxy, etc.).

Des mélanges de polyoléfines sont aussi possibles.

Le terme "polyoléfine fonctionnalisée" désigne les polymères d'alpha-oléfines et des motifs réactifs (les fonctionnalités); de tels motifs réactifs sont les fonctions acides, anhydrides, ou époxy.

À titre d'exemple, on peut citer les polyoléfines (c) précédentes greffées ou co- ou ter-polymérisées par des époxydes insaturés tels que le (méth)acrylate de glycidyle, ou par des acides carboxyliques ou les sels ou esters correspondants tels que l'acide (méth)acrylique (celui-ci pouvant être neutralisé totalement ou partiellement par des métaux tels que Zn, etc.) ou encore par des anhydrides d'acides carboxyliques tels que l'anhydride maléique.

La polyoléfine fonctionnalisée (d) peut être les (co)polymères suivants, greffés avec anhydride maléique ou méthacrylate de glycidyle, dans lesquels le taux de greffage est par exemple de 0,01 à 5% en poids:

- du PE, du PP, des copolymères de l'éthylène avec propylène, butène, hexène, ou octène contenant par exemple de 35 à 80% en poids d'éthylène ;
- des copolymères éthylène et acétate de vinyle (EVA), contenant jusqu'à 40% en poids d'acétate de vinyle ;
- des copolymères éthylène et (méth)acrylate d'alkyle, contenant jusqu'à 40% en poids de (méth)acrylate d'alkyle ;
- des copolymères éthylène et acétate de vinyle (EVA) et (méth)acrylate d'alkyle, contenant jusqu'à 40% en poids de comonomères ;
- les copolymères éthylène/propylène majoritaires en propylène greffés par de l'anhydride maléique puis condensés avec du polyamide (ou un oligomère de polyamide) monoaminé. Ces produits sont décrits dans EP-A-0 342 066.

La polyoléfine fonctionnalisée (d) peut aussi être un co- ou ter-polymère d'au moins les motifs suivants: (1) éthylène, (2) (méth)acrylate d'alkyle ou acide (méth)acrylique ou ester vinylique d'acide carboxylique saturé et (3) anhydride tel que anhydride maléique ou époxy tel que (méth)acrylate de glycidyle.

A titre d'exemple de polyoléfines fonctionnalisées de ce dernier type, on peut citer les copolymères suivants, où l'éthylène représente de préférence au moins 60% en poids et où le termonomère représente par exemple de 0,1 à 10% en poids du copolymère :

- les copolymères éthylène/(méth)acrylate d'alkyle ou acide (méth)acrylique/anhydride maléique ou méthacrylate de glycidyle ;
- les copolymères éthylène/acétate de vinyle/anhydride maléique ou méthacrylate de glycidyle ;
- les copolymères éthylène/acétate de vinyle/(méth)acrylate d'alkyle ou acide (méth)acrylique/anhydride maléique ou méthacrylate de glycidyle.

Dans les copolymères qui précèdent, l'acide (méth)acrylique peut être salifié avec Zn ou Li.

Le terme "(méth)acrylate d'akyle" désigne les méthacrylates et les acrylates d'alkyle en C1 à C6, et peut être choisi parmi l'acrylate de méthyle, l'acrylate d'éthyle, l'acrylate de n-butyle, l'acrylate d'iso-butyle, l'acrylate d'éthyl-2-hexyle, l'acrylate de cyclohexyle, le méthacrylate de méthyle et le méthacrylate d'éthyle.

Avantageusement, la polyoléfine fonctionnalisée (d) est un copolymère éthylène/acrylate de butyle/anhydride maléique ou un copolymère éthylène/acrylate d'éthyle/méthacrylate de glycidyle.

Par ailleurs, les polyoléfines précitées peuvent aussi être réticulées par tout procédé ou agent approprié (diépoxy, diacide, peroxy, etc); le terme polyoléfine fonctionnalisée comprend aussi les mélanges des polyoléfines précitées avec un réactif difonctionnel tel que diacide, dianhydride, diépoxy, etc. susceptible de réagir avec celles-ci.

Le poids moléculaire, l'indice MFI, la densité de ces polyoléfines fonctionnalisées peuvent aussi varier dans un large mesure, ce que l'homme de l'art appréciera.

Des mélanges de polyoléfines fonctionnalisées sont aussi possibles.

Le polymère (b) à blocs polyamide (PA) et blocs polyéther polyéthylèneglycol (PEG) est le constituant qui confère au matériau selon l'invention ses propriétés intéressantes.

Ces polymères à blocs polyamide et blocs polyéther PEG résultent de la copolycondensation de séquences polyamide à extrémités réactives avec des séquences polyéther à extrémités réactives, telles que, entre autres :

- séquences polyamide à extrémités diamines avec des séquences polyoxyalkylènes à extrémités dicarboxyliques ;
- séquences polyamide à extrémités dicarboxyliques avec des séquences polyoxyalkylènes à extrémités diamines obtenues par cyanoéthylation et hydrogénation de séquences polyoxyalkylène alpha-oméga dihydroxylées aliphatiques appelés polyétherdiols ;
- - séquences polyamide à extrémités diamines avec des séquences polyétherdiols, les produits obtenus étant dans ce cas particulier, des polyétheresteramides (ci-après PEEA).

De tels polymères sont décrits par exemple dans les brevets français 74 18913 et 77 26678, ainsi que dans les brevets suivants : US-P-4 331 786, US-P-4 115 475, US-P-4 195 015, US-P-4 839 441, US-P-4 864 014, US-P-4 230 838 et US-P-4 332 920, incorporés à la présente description.

Les séquences polyamide à extrémités dicarboxyliques proviennent, par exemple, de la condensation d'acides alpha-oméga aminocarboxyliques, de lactames ou de combinaisons sensiblement stoechiométriques de diacides carboxyliques et de diamines, en présence d'un diacide carboxylique limitateur de chaîne. Avantageusement, les blocs polyamide sont du PA6 ou du PA12. Le poids moléculaire moyen Mn des séquences polyamide PA varie de 300 à 15 000 et de préférence de 600 à 5 000.

Le polyéther est le polyéthylèneglycol (PEG).

Que les blocs polyéther soient dans la chaîne du polymère à blocs polyamide et blocs polyéther sous forme de diols ou de diamines, on les appelle par simplification blocs PEG. Le poids moléculaire moyen Mn des séquences polyéther est compris entre 100 et 6 000 et de préférence entre 300 et 3 000.

Les polymères à blocs polyamide et blocs polyéther peuvent aussi comprendre des motifs répartis de façon aléatoire. Ces polymères peuvent être préparés par la réaction simultanée du polyéther et des précurseurs des blocs polyamide. Par exemple, on peut faire réagir du polyétherdiol, un lactame (ou un alpha-oméga aminoacide correspondant) et un diacide limiteur de chaîne en présence d'un peu d'eau. On obtient un polymère ayant essentiellement des blocs polyéther, des blocs polyamide de longueur très variable, mais aussi les différents réactifs ayant réagi de façon aléatoire qui sont répartis de façon statistique le long de la chaîne polymère.

Ces polymères à blocs polyamide PA et blocs polyéther PEG présentent, par exemple, des duretés Shore D pouvant être comprise entre 20 et 75 et avantageusement entre 30 et 70, et une viscosité intrinsèque comprise entre 0,8 et 2,5 mesurée dans le métacrésol à 25°C pour une concentration initiale de 0,8 g/100 ml.

Ces polymères à blocs PA et blocs polyéther PEG peuvent être formés, en % en poids, de 5 à 85% de blocs polyéther PEG (et 95 à 15% de PA) et de préférence de 20 à 80% de blocs polyéther PEG (et 80 à 20% de PA), et plus préférentiellement de 30 à 60% de blocs polyéther PEG (et 70 à 30% de PA).

De préférence, le polymère à blocs polyamide et blocs polyéther comprend un seul type de bloc. On utilise avantageusement des polymères à blocs PA12 et blocs PEG et des polymères à blocs PA6 et blocs PEG.

On peut cependant aussi utiliser des mélanges de polymères à blocs polyamide et blocs polyéther.

De tels polymères à blocs polyamide et à blocs polyéther sont commercialisés par la société Elf Atochem sous la dénomination Pebax®.

Ces polymères à blocs PA et blocs PEG présentent des caractéristiques de perméabilité à la vapeur d'eau, et sont désignés comme étant "hydrophiles", suivant l'acceptation classique pour l'homme de l'art.

Ces polymères présentent la caractéristique surprenante de conférer à la phase thermoplastique à laquelle ils sont mélangés en des quantités nettement plus faibles que dans l'art antérieur :

- une propriété d'imperrespirabilité à des films obtenus à partir du matériau selon l'invention; et
- une propriété d'antistaticité aux objets obtenus à partir du matériau selon l'invention.

Ces propriétés sont obtenues alors même que le composant thermoplastique (polyamide et polyoléfine (fonctionnalisée)) forme la partie majoritaire, ce qui est surprenant puisqu'il est généralement admis dans l'art que les propriétés, en particulier de perméabilité aux gaz, sont conférées par la phase majoritaire. Ce résultat, surprenant et inattendu, permet donc de mélanger moins de matériau hydrophile tout en obtenant les propriétés voulues, abaissant par là les coûts du matériau final. Par ailleurs, le polymère (b) à blocs PEG selon l'invention, lorsqu'il est utilisé selon l'art antérieur en des quantités importantes (i.e. formant la majeure partie), pose des problèmes liés à une reprise en eau à l'équilibre trop élevée. Or, ces problèmes n'apparaissent pas avec les matériaux selon l'invention. L'invention fournit donc un matériau qui permet d'obvier les problèmes de reprise à l'eau tout en garantissant une perméabilité aux gaz élevée. De plus, les propriétés et les avantages sont obtenus quelle que soit la phase polyoléfinique du mélange et quelque soit le polyamide utilisé. Par ailleurs, les matériaux selon l'invention sont faciles à transformer, à extruder, etc, i.e. ils sont facilement "processable".

Le matériau selon l'invention peut aussi être mélangé à des additifs classiques.

Les films obtenus à partir du matériau selon l'invention sont imperrespirants, c'est-à-dire perméables à la vapeur d'eau mais imperméables à l'eau, et de façon générale perméables aux gaz mais imperméables aux liquides.

Ces films peuvent être préparés selon tout procédé connu dans l'art, par exemple par extrusion. Ces films présentent une épaisseur comprise par exemple entre 5 et 500 $\mu$m, de préférence entre 10 et 250 $\mu$m. Ces films peuvent être associés à d'autres films et/ou supports.

Les objets sont définis comme "antistatiques" car ils possèdent des caractéristiques d'antistaticité, à savoir leur résistivité surfacique est comprise par exemple entre $10^5$ et $10^{11}$ ohms/carré.

Ces objets peuvent être préparés selon tout procédé connu dans l'art, par exemple extrusion, injection, moulage, etc.

Les exemples suivants illustrent l'invention sans la limiter.

Exemples.

Dans les exemples, on utilise les constituants suivants.

- PEBA1: PEEA constitué de blocs PA6 (MW=1300) et de blocs polytétraméthylèneglycol PTMG (MW=650) et de dureté Shore D = 56.
- PEBA2: PEEA constitué de blocs PA6 (MW=1500) et de blocs PEG (MW=1500) et de dureté Shore D = 42.
- PA1: PA6 Ultramid B3 de BASF avec un MFI compris entre 17 et 20 (235°C/2,16kg).
- PA2: PA6 Ultramid B4 de BASF avec un MFI compris entre 3 et 4 (275°C/2,16kg).
- PO1: LLDPE Clearflex de Enichem avec un MFI de 0,8 (190°C/2,16kg) et une densité de 0,900.

- PO2: copolymère éthylène/acrylate de méthyle à 24% d'acrylate avec un MFI de 0,05 (190°C/2,16kg).
- PO3: PE métallocène Engage 8150 de Dow Chemical avec un MFI de 0,5 (190°C/2,16kg) et une densité de 0,868.
- POF1: terpolymère éthylène/acrylate de butyle/anhydride maléique de composition en poids 79,2/17,7/3,1 avec un MFI de 4,5 (190°C/2,16kg).
- POF2: terpolymère éthylène/acrylate d'éthyle/méthacrylate de glycidyle de composition en poids 67/25/8 avec un MFI de 4 à 8 (190°C/2,16kg).
- POF3: mélange comprenant en % en poids 75/22/3 de A/B/C où A est un terpolymère éthylène/acrylate de butyle/anhydride maléique avec un MFI de 6 à 8 (190°C/2,16kg), B est POF2, et C est un catalyseur (DMS) de la réaction anhydride maléique/méthacrylate de glycidyle; le DMS (DiMéthylSuifamine) se trouvant sous forme de granulés de mélange maître de DMS dans le comosant A.

Les conditions de mélange et d'extrusion sont identiques dans tous les exemples. On utilise une extrudeuse double vis corotative Werner Pfleiderer de diamètre 40 mm, L/D=40 (9 fourreaux + 4 entretoises soit une longueur totale de 10 fourreaux). On introduit par l'intermédiaire de trois ou quatre doseurs pondéraux indépendants les différents constituants (a), (b), éventuellement (c) et (d). Le débit total de l'extrudeuse est de 50 kg/h et la vitesse de rotation de la vis est de 150 tr/min. Les températures matière au niveau des fourreaux 4, 6, 8 et en tête sont respectivement de 230°C, 235°C, 240°C et 255°C. On dégaze en cours d'extrusion au niveau du fourreau 6 avec un vide partiel de +260 mmHg. Les joncs extrudés sont granulés puis étuvés sous vide 16 h à 70°C. Ces granulés sont ensuite extrudés dans des connditions standard sur une extrudeuse de laboratoire munie d'une filière à plat et d'un shill roll pour obtenir des films d'épaisseur environ 40 µm.

On mesure la perméabilité à la vapeur d'eau selon la norme ASTM 96 BW (38°C, 50%HR). La perméabilité est exprimée en gramme par m2 et par jour (g/m2/j).

Les résultats sont reportés dans le tableau ci-après.

| Exemple | A | B | C | D | 1 | 2 | 3 | 4 | 5 | 6 | 7 | 8 | 9 | 10 | 11 | 12 | 13 |
|---|---|---|---|---|---|---|---|---|---|---|---|---|---|---|---|---|---|
| PEBA1 | | | | 35 | | | | | | | | 35 | 35 | | 35 | | |
| PEBA2 | | | | | 35 | 40 | 30 | 20 | 10 | 35 | 35 | | | 35 | | 35 | 35 |
| FA1 | 100 | 65 | 60 | 25 | 25 | 20 | 30 | 40 | 50 | 25 | 25 | 25 | | 25 | 25 | 25 | |
| PA2 | | | | | | | | | | | | | 25 | | | | 25 |
| PO1 | | 25 | 32 | 32 | 32 | 32 | 32 | 32 | 32 | | | 32 | 32 | 32 | | | |
| PO2 | | | | | | | | | | 32 | | | | | | | |
| PO3 | | | | | | | | | | | 32 | | | | | | |
| POF1 | | 10 | 8 | 8 | 8 | 8 | 8 | 8 | 8 | 8 | 8 | | | | | | |
| POF2 | | | | | | | | | | | | 8 | 8 | 8 | | | |
| POF3 | | | | | | | | | | | | | | | 40 | 40 | 40 |
| a/b | | | | 0,71 | 0,71 | 0,5 | 1 | 2 | 5 | 0,71 | 0,71 | 0,71 | 0,71 | 0,71 | 0,71 | 0,71 | 0,71 |
| (a+b)/(c+d) | | | | 1,5 | 1,5 | 1,5 | 1,5 | 1,5 | 1,5 | 1,5 | 1,5 | 1,5 | 1,5 | 1,5 | 1,5 | 1,5 | 1,5 |
| b/(a+b+c+d) | | | | 0,35 | 0,35 | 0,4 | 0,3 | 0,2 | 0,1 | 0,35 | 0,35 | 0,35 | 0,35 | 0,35 | 0,35 | 0,35 | 0,35 |
| ép. (µm) | nd | nd | nd | 37 | 42 | 43 | 41 | 39 | 33 | 45 | 44 | 38 | 35 | nd | nd | nd | nd |
| Perméabilité (g/m2/j) | nd | nd | nd | 425 | 20528 | 23456 | 16502 | 2095 | 589 | 18699 | 17638 | 2166 | 301 | nd | nd | nd | nd |

nd: non déterminé

EP 0 842 969 A1

Les résultats montrent donc qu'avec une quantité minime de polymère à blocs PA6 et blocs PEG et une majorité d'une autre partie de polymère (polyamide en combinaison avec des polyoléfines), il est possible d'obtenir un film imperrespirant.

Les résultats montrent aussi que dans le cas d'une matrice polyamide, et quelque soit le taux de polyoléfine et polyoléfine fonctionnalisée, l'utilisation de PEEA hydrophobe (PEBA1) conduit à des matériaux qui ne sont pas imperrespirants (exemples D, 8, 9 et 11).

Les résultats montrent aussi que à taux de polyamide, polyoléfine et polyoléfine fonctionnalisée constants, le remplacement du PEEA hydrophobe par un PEEA hydrophile conduit à des matériaux imperrespirants (exemples 1, 6 et 7 versus D; exemples 10 versus 8 et 9, exemples 12 et 13 versus 11).

Les exemples montrent aussi que les propriétés d'imperrespirabilité sont directement fonction du taux de PEEA hydrophile dans la matrice (polyamide + PEEA). Lorsque les taux sont de 30%, 35% et 40%, les flux sont élevés.

Les exemples montrent encore qu'à taux de polyoléfine et polyoléfine fonctionnalisée constants, la nature de ces composants polyoléfiniques n'a que très peu d'influence sur les propriétés d'imperrespirabilité (exemples 1, 6, 7, 10, 12 et 13).

Bien entendu, la présente invention n'est pas limitée aux modes de réalisation indiqués, mais est susceptible de nombreuses variantes aisément accessibles à l'homme de l'art.

**Revendications**

1. Matériau comprenant :

    (a) un polyamide;
    (b) un polymère à blocs PA et blocs polyéther PEG;
    (c) éventuellement une polyoléfine;
    (d) une polyoléfine fonctionnalisée,

    les divers constituants étant présents en des quantités pondérales a, b, c et d, telles que :

    $a > 0$; $b > 0$; $c + d > 0$; $a + b + c + d = 100$; avec
    $a/b > 0{,}2$; $(a + b)/(c + d) > 1$; et $b/(a + b + c + d) < 0{,}5$.

2. Matériau selon la revendication 1, dans lequel les divers constituants sont présents en des quantités pondérales a, b, c et d telles que :

$$2 > a/b > 0{,}5.$$

3. Matériau selon la revendication 1 ou 2, dans lequel les divers constituants sont présents en des quantités pondérales a, b, c et d telles que :

$$0{,}3 < b/(a + b + c + d) < 0{,}5.$$

4. Matériau selon l'une quelconque des revendications 1 à 3, dans lequel dans le polymère (b), les blocs PA sont des blocs PA6.

5. Matériau selon l'une quelconque des revendications 1 à 4, dans lequel le polyamide est du PA6.

6. Matériau selon l'une quelconque des revendications 1 à 3, dans lequel le polyamide est du PA6 et le polymère à blocs PA et blocs polyéther PEG est un polymère à blocs PA6/PEG.

7. Matériau selon l'une quelconque des revendications 1 à 3, dans lequel le polyamide est du PA6,6 et le polymère à blocs PA et blocs polyéther PEG est un polymère à blocs PA6/PEG.

8. Matériau selon l'une quelconque des revendications 1 à 3, dans lequel le polyamide est du PA12 et le polymère à blocs PA et blocs polyéther PEG est un polymère à blocs PA12/PEG.

**9.** Matériau selon l'une quelconque des revendications 1 à 3, dans lequel le polyamide est du PA6 et le polymère à blocs PA et blocs polyéther PEG est un polymère à blocs PA12/PEG.

**10.** Matériau selon l'une quelconque des revendications 1 à 9, dans lequel la polyoléfine fonctionnalisée (d) est choisie parmi :

(d1) homo- ou copolymères d'éthylène et d'alpha-oléfine avec un monomère acide carboxylique, un anhydride d'un tel acide, un sel d'un tel acide, un époxyde insaturé, ledit monomère étant greffé ou terpolymérisé;
(d2) copolymères éthylène/(méth)acrylate d'alkyle/monomère insaturé à fonction acide carboxylique ou anhydride d'acide carboxylique, ledit monomère étant greffé ou terpolymérisé;
(d3) copolymères éthylène/(méth)acrylate d'alkyle/monomère insaturé à fonction époxy, ledit monomère étant greffé ou terpolymérisé;
(d4) copolymères éthylène/esters vinyliques d'acide carboxylique/monomère insaturé à fonction acide carboxylique ou anhydride d'acide carboxylique, ledit monomère étant greffé ou terpolymérisé;

ces polyoléfines fonctionnalisées étant éventuellement mélangées avec un réactif difonctionnel.

**11.** Matériau selon l'une quelconque des revendications 1 à 10, dans lequel la polyoléfine fonctionnalisée (d) est un copolymère éthylène/acrylate de butyle/anhydride maléique.

**12.** Matériau selon l'une quelconque des revendications 1 à 10, dans lequel la polyoléfine fonctionnalisée (d) est un copolymère éthylène/acrylate d'éthyle/méthacrylate de glycidyle.

**13.** Matériau selon l'une quelconque des revendications 1 à 12, dans lequel la polyoléfine (c) est du polyéthylène.

**14.** Film imperrespirant obtenu à partir du matériau selon l'une quelconque des revendications 1 à 13.

**15.** Objet antistatique obtenu à partir du matériau selon l'une quelconque des revendications 1 à 13.

**Office européen des brevets**

## RAPPORT DE RECHERCHE EUROPEENNE

Numéro de la demande

EP 97 40 2684

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| D,A | EP 0 476 963 A (CHICOPEE) 25 mars 1992<br>--- | | C08J5/18<br>C08L77/00<br>C08L77/12 |
| A | EP 0 560 630 A (MCNEIL PPC INC) 15 septembre 1993<br>--- | | |
| D,A | EP 0 378 015 A (ATOCHEM ELF SA) 18 juillet 1990<br>--- | | |
| A | DATABASE WPI<br>Section Ch, Week 8920<br>Derwent Publications Ltd., London, GB;<br>Class A23, AN 89-147431<br>XP002035484<br>& JP 01 090 236 A (NIPPON OILS & FATS CO LTD) , 6 avril 1989<br>* abrégé *<br>----- | | |

| DOMAINES TECHNIQUES RECHERCHES (Int.Cl.6) |
|---|
| C08J<br>C08L |

Le présent rapport a été établi pour toutes les revendications

| Lieu de la recherche | Date d'achèvement de la recherche | Examinateur |
|---|---|---|
| LA HAYE | 27 novembre 1997 | Leroy, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)